# EUROPÄISCHE PATENTSCHRIFT

(11) **EP 0 389 863 B1**
(45) Veröffentlichungstag und Bekanntmachung des Hinweises auf die Patenterteilung: **18.12.1996**
(21) Anmeldenummer: 90104737.3
(22) Anmeldetag: 13.03.1990
(51) Int. Cl.: H01L 21/225, H01L 29/06, H01L 29/36

(54) **Verfahren zur Herstellung eines planaren pn-Übergangs hoher Spannungsfestigkeit**
Process for manufacturing a high-voltage withstanding planar p-n junction
Procédé de fabrication d'une jonction p-n planaire à haute tenue en tension

(30) Priorität: 29.03.1989 DE 3910168
(43) Veröffentlichungstag der Anmeldung: 03.10.1990
(73) Patentinhaber: SIEMENS AKTIENGESELLSCHAFT, 80333 München (DE)
(72) Erfinder: Schulze, Hans-Joachim, Dr., D-8012 Ottobrunn (DE); Kuhnert, Reinhold, Dr., D-8000 München 19 (DE)

(56) Entgegenhaltungen:
- EP-A- 0 176 778
- EP-A- 0 262 356
- EP-A- 0 263 270
- FR-A- 2 356 276
- IEEE TRANS. ON ELECTRON DEVICES, Band ED-27, Nr. 5, Mai 1980, Seiten 977-982, IEEE, New York, US; V.A.K. TEMPLE: "Practical aspects of the depletion etch method in high-voltage devices"

## Beschreibung

Die Erfindung bezieht sich auf ein Verfahren zur Herstellung eines planaren pn-Übergangs hoher Spannungsfestigkeit nach dem Oberbegriff des Patentanspruchs 1.

Ein solches Verfahren ist aus der EP-A-0 262 356 bekannt. Hier wird bei der Erzeugung des Halbleitergebiets so vorgegangen, daß zunächst eine homogene Belegung des Halbleiterkörpers an seiner oberen Grenzfläche mit dem Dotierstoff erfolgt und die auf diese Weise gebildete Belegungsschicht durch einen maskierten Ätzschritt strukturiert, d.h. mit Ausnehmungen versehen wird. Beim sich anschließenden Temperschritt können die durch die Ausnehmungen entfernten Teile der Belegungsschicht nicht mehr als lokale Dotierstoffquellen wirken, so daß im Randbereich des Halbleitergebiets ein lateraler Dotierungsgradient entsteht, d.h. daß der Randbereich eine mit wachsender Entfernung vom zentralen Teil des Halbleitergebiets abnehmende Dotierungskonzentration aufweist.

Ein anderes Verfahren dieser Art ist aus der EP-A-0 176 778 und der Zeitschrift IEEE Trans. ED, 33 (1986), S. 426, bekannt.

Beide vorstehend genannte Verfahren sind in der Zeitschrift Solid-State Electronics, Vol. 32, 1989, No. 2, S. 175 und 176, erwähnt und werden dort als VLD-Verfahren (variation of lateral doping concentration) bezeichnet. Die genaue Einstellung eines gewünschten Wertes der Oberflächen-Durchbruchspannung des pn-Übergangs hängt jedoch maßgeblich von dem in lateraler Richtung vorhandenen Dotierungsprofil des Randbereichs und damit von der Strukturierung der Belegungsschicht bzw. einer verwendeten Dotierungsmaske ab. Danach erfordert aber jede Änderung der gewünschten Durchbruchspannung eine relativ aufwendige Änderung des Herstellungsverfahrens. Ebenso bedingt jede Änderung der Eindringtiefe des Halbleitergebiets oder jede Änderung der Dotierungskonzentration in den den pn-Übergang bildenden Halbleiterteilen eine relativ komplizierte Anpassung einzelner Verfahrensschritte bei der Einfügung des Halbleitergebiets, wenn eine vorgegebene Oberflächen-Durchbruchsspannung erreicht werden soll.

Ferner ist aus der französischen Anmeldeschrift mit der Veröffentlichungsnummer 2 356 276 eine Einstellung der Durchbruchsspannung eines Mehrschichtbauelements, zum Beispiel eines Transistors, Thyristors oder Triacs, durch Entfernung eines von der oberen Grenzfläche ausgehenden Teils des Randbereichs eines Halbleitergebiets mit Hilfe eines Ätzschrittes bekannt.

Der Erfindung liegt die Aufgabe zugrunde, ein Verfahren der eingangs genannten Art anzugeben, das in einfacher Weise an unterschiedliche strukturelle Gegebenheiten oder unterschiedliche Werte der gewünschten Oberflächen-Durchbruchspannung angepaßt werden kann, das die Herstellung eines planaren pn-Übergangs mit einer vorgegebenen Oberflächen-Durchbruchspannung mit großer Sicherheit und Wiederholbarkeit gewährleistet und das gleichzeitig eine Verbesserung der Sperreigenschaften eines pn-Übergangs bewirkt. Dies wird erfindungsgemäß durch eine Ausbildung nach dem kennzeichnenden Teil des Patentanspruchs 1 erreicht.

Der mit der Erfindung erzielbare Vorteil liegt insbesondere darin, daß die bei fester, vorgegebener Oberflächen-Durchbruchspannung erforderliche Anpassung des Herstellungsverfahrens an unterschiedliche strukturelle Gegebenheiten oder die bei unveränderter Struktur erforderliche Anpassung des Herstellungsverfahrens an einen unterschiedlichen Wert der Oberflächen-Durchbruchspannung erst nach dem Temperschritt erfolgt, und zwar im wesentlichen durch die Wahl der Ätztiefe beim Ätzschritt, so daß die vorhergehenden Verfahrensschritte hiervon nicht beeinflußt werden.

Die Ansprüche 2 und 3 stellen vorteilhafte Weiterbildungen des Verfahrens nach der Erfindung dar. Die Ansprüche 4 bis 7 sind auf bevorzugte Anwendungen des erfindungsgemäßen Verfahrens gerichtet.

Die Erfindung wird nachfolgend anhand der Zeichnung näher erläutert. Dabei zeigen:
- Figur 1 bis Figur 4: Querschnittsdarstellungen eines Halbleiterkörpers zur Erläuterung eines Verfahrens nach der Erfindung,
- Figur 5 und Figur 6: Querschnittsdarstellungen eines Halbleiterkörpers zur Erläuterung einer Weiterbildung eines Verfahrens nach der Erfindung und
- Figur 7 bis Figur 9: nach dem erfindungsgemäßen Verfahren hergestellte Halbleiter-Bauelemente.

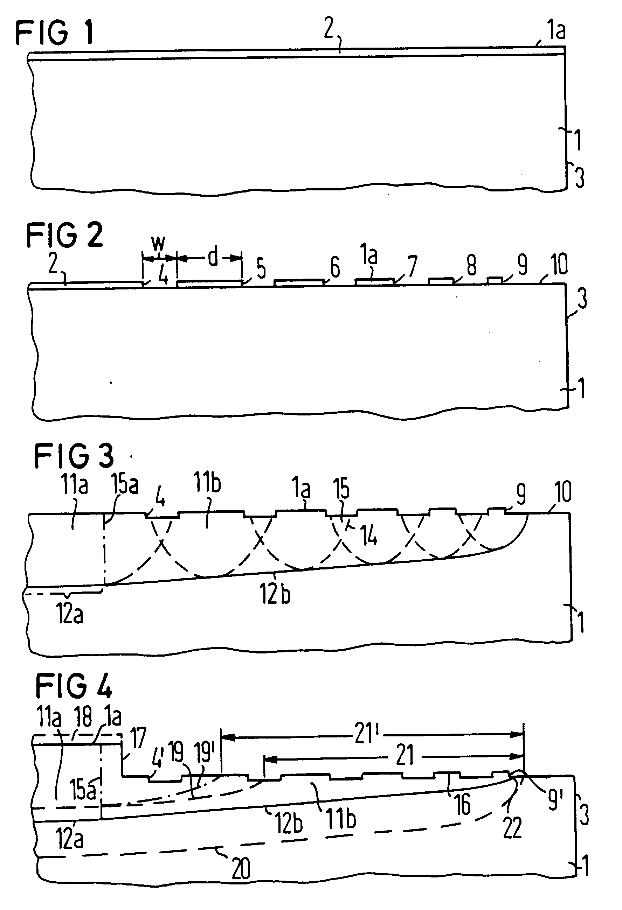

In Figur 1 ist ein Halbleiterkörper 1, z.B. aus n-dotiertem Silizium, mit einer Dotierungskonzentration von z.B. 10¹⁴cm⁻³ dargestellt, in den ein p-leitendes Halbleitergebiet eingefügt werden soll. Hierzu wird ein eine p-Leitung bewirkender Dotierstoff, z.B. Al, in eine von der oberen Grenzfläche la des Halbleiterkörpers ausgehende Zone 2 eingebracht, und zwar mittels eines ersten, auch als "predeposition" bezeichneten Verfahrensschrittes. Dabei wird eine Diffusionsquelle verwendet, die bei einer vorgegebenen Temperatur von z.B. 1060°C innerhalb eines vorgegebenen Zeitraums von z.B. 7 Stunden den Dotierstoff durch die Grenzfläche la in die Zone 2 einbringt. Diesen Vorgang kann man auch als eine Belegung des Halbleiterkörpers 1 im Bereich seiner oberen Grenzfläche la mit dem Dotierstoff auffassen. Die Zone 2 weist z.B. eine Eindringtiefe von 5 bis 10 µm und eine randseitige Dotierungskonzentration in unmittelbarer Nähe der Grenzfläche la von 10¹⁹cm⁻³ auf. Der Halbleiterkörper 1 hat vorzugsweise die Form einer flachen zylindrischen Scheibe mit kreisförmiger lateraler Begrenzung, wobei in der Zeichnung aus Gründen einer einfachen Darstellung nur der Querschnitt eines vom rechten Rand 3 ausgehenden Teils des Halbleiterkörpers dargestellt ist. Auch in vertikaler Richtung ist nur ein von der oberen Grenzfläche la ausgehender Teil des Halbleiterkörpers gezeigt.

In einem zweiten Verfahrensschritt wird die Zone 2 in der aus Figur 2 ersichtlichen Weise strukturiert. Hierbei werden in der Zone 2 Ausnehmungen 4 bis 9 vorgesehen. Im einzelnen wird zunächst die Grenzfläche la mit einer Ätzmaske bedeckt, die durch an sich bekannte photolithographische Schritte so strukturiert wird, daß sie an den Stellen, an denen die Ausnehmungen 4 bis 9 vorgesehen sind, entfernt wird. In einem sich anschließenden Ätzvorgang werden dann die sich bis zur unteren Grenzfläche 10 der Zone 2 erstreckenden Ausnehmungen 4 bis 9 erzeugt. Die Ausnehmung 9 verläuft dabei entlang des äußeren Randes des Halbleiterkörpers 1, während die Ausnehmungen 4 bis 8 einen vorgegebenen Abstand von diesem haben. Die Bodenflächen der Ausnehmungen 4 bis 9 weisen bei der erwähnten Form des Halbleiterkörpers 1 die Form von konzentrischen Kreisringen auf. Bezeichnet man, wie in Figur 2 angedeutet ist, die Breite der einzelnen Ausnehmungen mit w und den Abstand zweier nebeneinander liegender Ausnehmungen mit d, so nimmt die Größe d/w mit fortschreitendem Abstand zweier durch d voneinander getrennter Ausnehmungen von dem linksseitigen Rand der Ausnehmung 4 stetig ab.

In einem auch als Nachdiffusion bezeichneten Temperschritt wird sodann der in Figur 2 teilweise dargestellte Halbleiterkörper ohne die obengenannte Diffusionsquelle während einer vorgegebenen Zeitspanne von z.B. 20 Stunden einer Temperatur von etwa 1240°C ausgesetzt. Dabei diffundieren während der Belegung eingebrachte Dotierstoffatome aus den gemäß Figur 2 verbliebenen Teilen der Zone 2 weiter in den Halbleiterkörper 1 ein, so daß gemäß Figur 3 ein p-leitendes Gebiet 11a, 11b entsteht, das durch einen pn-Übergang von dem übrigen Teil des Halbleiterkörpers 1 getrennt ist. Die aus dem zentralen, keine Ausnehmungen 4 bis 9 aufweisen den Teil der Zone 2 eindiffundierten Dotierstoffatome bewirken, daß ein zentraler, in Figur 3 nur zum Teil dargestellter Abschnitt 12a des pn-Übergangs im wesentlichen parallel zur Grenzfläche 1a verläuft. Die Dotierstoffatome, die aus den zwischen den Ausnehmungen 4 bis 9 stehengebliebenen, ringförmigen Teilen der Zone 2 eindiffundieren, ergeben einen sich allmählich der Grenzfläche 1a bzw. der Bodenfläche 10 der Ausnehmung 9 annähernden Abschnitt 12b des pn-Übergangs. Die gestrichelten Linien 14 deuten an, daß jedes dieser stehengebliebenen Teile der Zone 2 als eine lokale Dotierstoffquelle wirkt. Da sich die von den einzelnen lokalen Dotierstoffquellen erzeugten, durch die gestrichelten Linien 14 angedeuteten, umdotierten Halbleitergebiete in ihren Randbereichen, z.B. bei 15, überlappen, bewirken die in den Überlappungsbereichen entstehenden, weiteren lokalen Dotierstoffquellen, daß der in Figur 3 angedeutete, glatte Verlauf des Abschnitts 12b entsteht.

Die anhand der Figuren 1 bis 3 beschriebenen Verfahrensschritte sind bereits aus der EP-A-0 262 356 bekannt und dort auch im einzelnen beschrieben. Abweichend hiervon kann jedoch die Struktur gemäß Figur 3 auch nach einem anderen VLD-Verfahren hergestellt werden, das im einzelnen in der EP-A-0 176 778 beschrieben und dargestellt ist. Dabei wird der das p-leitende Gebiet 11a, 11b erzeugende Dotierstoff mittels einer Diffusion oder einer Ionenimplantation durch die Öffnungen einer Dotierungsmaske in den Halbleiterkörper 1 eingebracht, wobei die Dotierungsmaske außerhalb einer den zentralen Teil 11a des Halbleitergebiets 11a, 11b definierenden Öffnung noch eine Vielzahl von kleineren zusätzlichen Öffnungen aufweist, die mit zunehmendem Abstand von der ersteren Öffnung jeweils kleiner bemessen und/ oder weiter voneinander entfernt sind. Nach dem Einbringen des Dotierstoffes sind unterhalb der einzelnen Maskenöffnungen eine Vielzahl von lokalen Dotierstoffquellen vorhanden, die nach einem sich anschließenden Temperschritt, der dem oben beschriebenen Temperschritt entspricht, im Halbleiterkörper 1 das Halbleitergebiet 11a, 11b mit dem bereits beschriebenen pn-Übergang 12a, 12b erzeugen.

Der in Figur 3 mit 12b bezeichnete Abschnitt des pn-Übergangs begrenzt den rechts von der strichpunktierten Linie 15 a liegenden Randbereich 11b des Halbleitergebiets, während der links von dieser Linie liegende zentrale Bereich 11a durch den Abschnitt 12a des pn-Übergangs begrenzt wird. Bei der oben erwähnten Ausbildung des Halbleiterkörpers 1 als flache zylindrische Scheibe mit kreisförmiger lateraler Begrenzung weist der Querschnitt des Randbereichs 11b die Form eines Kreisrings auf, der den im Querschnitt kreisförmigen zentralen Teil 11a lateral umschließt. 11b besitzt über seiner ganzen, radial gemessenen Breite eine mit steigender lateraler Entfernung vom zentralen Teil 11a abnehmende Dotierungs-Randkonzentration. Die radial gemessene Breite von 11b übersteigt dabei die durch den vertikalen Abstand von 12a und 1a gegebene Eindringtiefe des zentralen Teiles 11a des Halbleitergebiets.

Ausgehend von der Struktur nach Figur 3 wird nun ein von der oberen Grenzfläche 1a ausgehender Teil des Randbereichs 11b des Halbleitergebiets bis auf das Niveau einer horizontalen Begrenzungsfläche 16 entfernt, wobei nur die in Figur 4 links von der vertikalen Stufe 17 und die unterhalb der Fläche 16 liegenden Teile des Halbleitergebiets 11a, 11b bestehen bleiben. Auch die den weggenommenen Teil des Halbleitergebiets 11a, 11b lateral umgebende Zone des Halbleiterkörpers 1 wird nach Figur 4 mit entfernt, wobei die Fläche 16 die Form eines Kreisrings aufweist, dessen äußerer Durchmesser durch den seitlichen Rand 3 und dessen innerer Durchmesser durch die Stufe 17 gegeben ist. Die Entfernung der oberhalb von 16 und lateral außerhalb von 17 liegenden Teile des Randbereichs 11b und des Halbleiterkörpers 1 erfolgt mittels einer naßchemischen Ätzung (CP-Ätzung) oder einer Plasmaätzung. Dabei wird eine Lackmaske 18 auf der Begrenzungsfläche 1a aufgebracht und durch photolithographische Schritte von den lateral außerhalb der Stufe 17 liegenden Teilen der Grenzfläche 1a wieder entfernt. Die Einwirkungsdauer des Ätzmittels auf die von der Lackmaske nicht bedeckten Halbleiterteile wird so gewählt, daß eine bestimmte Tiefe der Stufe 17 und ein damit zusammenhängender Wert der Oberflächen-Durchbruchspannung des pn-Übergangs 12a, 12b erreicht werden. Für die in Figur 4 angedeutete Tiefe der Ätzstufe 17 kann man beim Anlegen einer Sperrspannung an den pn-Übergang 12a, 12b die oberen und unteren Begrenzungen der sich an diesem aufbauenden Raumladungszone etwa durch gestrichelte Linien 19 und 20 andeuten. Die mit dem Doppelpfeil 21 gekennzeichnete, in der Begrenzungsfläche 16 gemessene Entfernung der Begrenzungen 19 und 20 voneinander stellt ein Maß für die Öberflächen-Durchbruchspannung des pn-Übergangs 12a, 12b dar. Vergrößert man die Ätztiefe der Stufe 17, so wird hierdurch der Verlauf der oberen Begrenzung 19 der Raumladungszone zum Beispiel in den mit 19′ bezeichneten, strichpunktierten Verlauf abgeändert. Damit ist aber eine Vergrößerung des in 16 gemessenen Abstandes der Begrenzungen 19′ und 20 auf den Betrag des Doppelpfeils 21′ verbunden, was eine Vergrößerung der Oberflächen-Durchbruchspannung bedeutet.

Durch die Wahl der Einwirkungsdauer des Ätzmittels wird danach eine vorgegebene Oberflächen-Durchbruchspannung in einfacher Weise eingestellt. Ausgehend von einem bestimmten, durch die strukturellen Gegebenheiten bedingten Verlauf der ohne die Ätzstufe 17 vorhandenen Begrenzungen der Raumladungszone am pn-Übergang 12a, 12b gelingt es allein durch eine entsprechend gewählte Bemessung der Tiefe der Stufe 17, einen bestimmten Abstand zwischen den Begrenzungen 19 und 20 bzw. 19' und 20 in der Fläche 16 einzustellen, der dann dem gewünschten Wert der Oberflächen-Durchbruchspannung entspricht. Dabei kann auch der Teil des Halbleiterkörpers 1, der den durch die Ätzung entfernten Teil des Randbereichs llb lateral umgibt, bestehen bleiben, was dann der Fall ist, wenn die Ätzmaske nur zwischen der Stufe 17 und der lateralen Begrenzung 22 des pn-Übergangs 12a, 12b entfernt wird. Die Bezugszeichen 4' und 9' in Figur 4 deuten an, daß die Ausnehmungen 4 bis 9 der Zone 2 durch die Ätzung in ähnlich ausgeformte Vertiefungen 4' bis 9' der Fläche 16 übertragen werden. Bei einer praktischen Erprobung des Einflusses des vertikalen Profils der Halbleiterstruktur 1, lla, llb auf die Spannungsfestigkeit des pn-Übergangs ergab sich, daß bei einer Eindringtiefe des zentralen Bereichs lla des Halbleitergebiets lla, llb von 50 µm eine Ätztiefe der Stufe 17 von etwa 20 µm den gleichen Wert der Oberflächen-Durchbruchspannung ergab, wie eine Ätztiefe von etwa 35 µm bei einer Eindringtiefe von 100 µm. Es stellte sich weiterhin heraus, daß keine hohen Anforderungen an die Ätzgenauigkeit zu stellen sind.

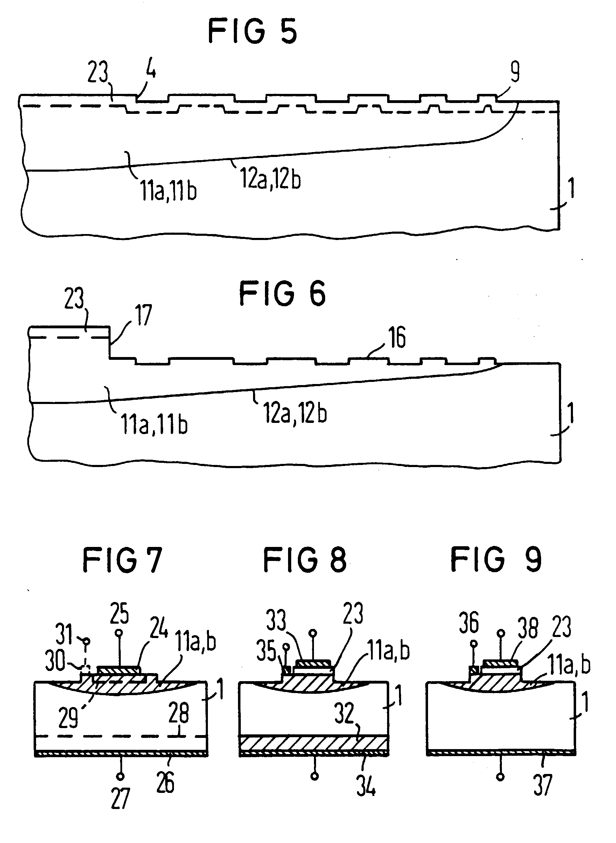

Das anhand der Figuren 5 und 6 erläuterte Verfahren nach der Erfindung sieht vor, daß in die Struktur gemäß Figur 3 zunächst ein eine p-Leitung bewirkender Dotierstoff, zum Beispiel Bor, in eine oberflächenseitige Schicht 23 des Halbleiterkörpers eingebracht wird (Figur 5), bevor mittels des bereits beschriebenen Ätzschrittes die Wegnahme der in lateraler Richtung außerhalb der Ätzstufe 17 und der oberhalb der Fläche 16 liegenden Halbleiterteile erfolgt. Hierdurch entsteht die in Figur 6 dargestellte Struktur, wobei die oberflächenseitige Schicht 23, deren Eindringtiefe kleiner bemessen ist als die Ätzstufe 17, nur in dem zentralen Teil des Halbleiterkörpers 1 innerhalb der Ätzstufe 17 bestehen bleibt. Die verstärkte Dotierung der Schicht 23 in Figur 5 stellt eine Getterungsschicht dar, die eine Entfernung unerwünschter prozeßinduzierter Defekte aus dem Halbleiterkörper 1 und damit eine Verbesserung der Sperreigenschaften des pn-Übergangs 12a, 12b bewirkt.

Nach einer Variation dieser Weiterbildung wird die als Getterungsschicht dienende, oberflächenseitige Schicht 23 gemäß Figur 5 mit einem eine n-Leitung bewirkenden Dotierstoff, zum Beispiel Phosphor, dotiert, sofern der gemäß Figur 6 bestehen bleibende Teil von 23 zusätzlich die Funktion eines in das p-leitende Halbleitergebiet 11a, 11b eingefügten, n-leitenden Halbleitergebiets erfüllen soll.

Figur 7 zeigt unter Weglassung der gestrichelten Zeichnungsteile eine durch ein Verfahren nach der Erfindung hergestellte Halbleiterdiode. Dabei entsprechen das Halbleitergebiet 11a, 11b dem p-Emitter und der Halbleiterkörper 1 dem n-Emitter derselben. Der p-Emitter wird mit einer Elektrode 24 versehen, die einen Anschluß 25 aufweist. Der n-Emitter wird von einer kathodenseitigen Elektrode 26 kontaktiert, der mit einem Anschluß 27 versehen ist.

Weiterhin dient die Figur 7 mit den gestrichelten Zeichnungsteilen zur Darstellung eines Thyristors, der nach der Erfindung hergestellt worden ist. Hierbei bedeuten das Halbleitergebiet 11a, 11b die p-Basis, der Halbleiterkörper 1 die n-Basis, eine unterhalb der gestrichelten Linie 28 in den Halbleiterkörper 1 eingefügte p-leitende Halbleiterschicht den p-Emitter und ein durch die gestrichelte Linie 29 abgegrenztes, in das Halbleitergebiet 11a, 11b eingefügtes n-leitendes Halbleitergebiet den n-Emitter. 25 ist hier der kathodenseitige Anschluß und 27 der anodenseitige Anschluß des Thyristors, während eine das Gebiet 11a, 11b kontaktierende Elektrode 30 mit einem Anschluß 31 die Steuerelektrode des Thyristors darstellt.

Figur 8 stellt einen nach der genannten Weiterbildung des Verfahrens nach der Erfindung hergestellten Thyristor dar. Das Gebiet 11a, 11b entspricht der p-Basis, der Halbleiterkörper 1 der n-Basis, eine in 1 eingefügte, p-leitende Schicht 32 dem p-Emitter und der eingefügte Teil der oberflächenseitigen Schicht 23 dem n-Emitter des Thyristors. Die Teile 23, 32 und 11a, 11b sind jeweils mit einer kathodenseitigen Elektrode 33, einer anodenseitigen Elektrode 34 und einer Steuerelektrode 35 versehen.

Figur 9 zeigt einen bipolaren Transistor, der nach der Weiterbildung des Verfahrens nach der Erfindung hergestellt worden ist. Dabei stellen das Gebiet 11a, 11b die p-Basis, der n-leitende Halbleiterkörper 1 den Kollektor und der eingefügte Teil der oberflächenseitigen n-leitenden Schicht 23 den Emitter dar. Die diese Teile kontaktierenden Elektroden sind mit 36, 37 und 38 bezeichnet.

Andere Ausführungsformen des erfindungsgemäßen Verfahrens betreffen die Einfügung von n-leitenden Halbleitergebieten in p-dotierte Halbleiterkörper. Hierbei wird als Dotierstoff zum Beispiel Phosphor verwendet.

## Patentansprüche

1. Verfahren zur Herstellung eines planaren pn-Übergangs hoher Spannungsfestigkeit, der ein in einen dotierten Halbleiterkörper (1) eines ersten Leitungstyps eingefügtes Halbleitergebiet (11a, 11b) eines zweiten Leitungstyps vom übrigen Teil des Halbleiterkörpers (1) trennt, wobei der den Randbereich (11b) des Halbleitergebiets begrenzende Teil (12b) des pn-Übergangs sich der oberen Grenzfläche (1a) allmählich annähert, die Breite des Randbereichs (11b) des Halbleitergebiets die Eindringtiefe desselben übersteigt und der Randbereich (11b) über seiner ganzen Breite eine mit steigender Entfernung vom zentralen Teil (11a) des Halbleitergebiets abnehmende Dotierungskonzentration aufweist, bei dem ein zur Bildung des Halbleitergebiets (11a, 11b) dienender Dotierstoff zunächst durch die obere Grenzfläche (1a) in den Halbleiterkörper (1) eingebracht wird und ein Teil des eingebrachten Dotierstoffs durch einen Temperschritt tiefer in den Halbleiterkörper (1) eindiffundiert wird, dadurch gekennzeichnet, daß nach dem Temperschritt ein von der oberen Grenzfläche (1a) ausgehender Teil des Randbereichs (11b) des Halbleitergebiets durch einen Ätzschritt entfernt wird, wobei die Ätztiefe (17) so bemessen wird, daß die Oberflächen-Durchbruchspannung des in Sperrichtung vorgespannten pn-Übergangs (12a, 12b) auf einen vorgegebenen Wert eingestellt wird, daß durch den Ätzschritt zugleich mit dem genannten Teil des Randbereichs (11b) des Halbleitergebiets auch eine Randzone des Halbleiterkörpers (1) mit entfernt wird, die diesen Teil des Randbereichs (11b) lateral umschließt, daß vor dem Ätzschritt in eine oberflächenseitige Schicht (23) des Halbleitergebiets (11a, 11b) und des Halbleiterkörpers (1) ein Dotierstoff eingebracht wird, und daß diese oberflächenseitige Schicht (23) durch den Ätzschritt aus dem Randbereich (11b) des Halbleitergebiets (11a, 11b) und aus der diesen umgebenden Randzone des Halbleiterkörpers (1) wieder entfernt wird.

2. Verfahren nach Anspruch 1, **dadurch gekennzeichnet**, daß der in die oberflächenseitige Schicht (23) des Halbleitergebiets (11a, 11b) und des Halbleiterkörpers (1) eingebrachte Dotierstoff die Dotierung des Halbleitergebiets (11a, 11b) verstärkt.

3. Verfahren nach Anspruch 1, **dadurch gekennzeichnet**, daß der in die oberflächenseitige Schicht (23) des Halbleitergebiets (11a, 11b) und des Halbleiterkörpers (1) eingebrachte Dotierstoff das Halbleitergebiet (11a, 11b) in der Nähe der oberen Grenzfläche (1a) umdotiert.

4. Anwendung des Verfahrens nach Anspruch 1 oder 2 zur Herstellung eines Thyristors, wobei das Halbleitergebiet (11a, 11b) die p-Basis und der Halbleiterkörper (1) die n-Basis bilden, der p-Emitter im Bereich der unteren Grenzfläche des Halbleiterkörpers durch dieselben Diffusionsschritte wie die p-Basis, jedoch mit einer konstanten Dotierungskonzentration in lateraler Richtung, erzeugt wird und der n-Emitter durch einen zusätzlichen Dotierungsschritt in das Halbleitergebiet (11a, 11b) eingefügt wird.

5. Anwendung des Verfahrens nach Anspruch 3 zur Herstellung eines Thyristors, wobei das Halbleitergebiet (11a, 11b) die p-Basis, der Halbleiterkörper (1) die n-Basis und der in das Halbleitergebiet eingefügte Teil der oberflächenseitigen Schicht (23) den n-Emitter bilden und der p-Emitter (32) im Bereich der unteren Grenzfläche des Halbleiterkörpers (1) durch dieselben Diffusionsschritte wie die p-Basis, jedoch mit einer konstanten Dotierungskonzentration in lateraler Richtung, erzeugt wird.

6. Anwendung des Verfahrens nach einem der Ansprüche 1 oder 2 zur Herstellung einer Diode, wobei das Halbleitergebiet (11a, 11b) den p-Emitter und der Halbleiterkörper (1) den n-Emitter derselben bilden.

7. Anwendung des Verfahrens nach Anspruch 3 zur Herstellung eines bipolaren Transistors, wobei das Halbleitergebiet (11a, 11b) die Basis, der Halbleiterkörper (1) den Kollektor und der in das Halbleitergebiet (11a,11b) eingefügte Teil der oberflächenseitigen Schicht (23) oen Emitter bilden.

## Claims

1. Method for the production of a planar pn-junction having a high withstand voltage, which separates a semiconductor region (11a, 11b), which is inserted into a doped semiconductor body (1) of a first conductivity type, of a second conductivity type from the remaining part of the semiconductor body (1), that part (12b) of the pn-junction which bounds the edge region (11b) of the semiconductor region gradually approaching the upper boundary surface (1a), the width of the edge region (11b) of the semiconductor region exceeding the penetration depth of the same, and the edge region (11b) having a doping concentration over its entire width which decreases as the distance from the central part (11a) of the semiconductor region increases, in the case of which a dopant which is used to form the semiconductor region (11a, 11b) is initially introduced into the semiconductor body (1) through the upper boundary surface (1a), and some of the dopant which is introduced being diffused into the semiconductor body (1) more deeply by means of a heat-treatment step, characterized in that, after the heat-treatment step, a part of the edge region (11b) of the semiconductor region which originates from the upper boundary surface (1a) is removed by means of an etching step, the etching depth (17) being dimensioned such that the surface breakdown voltage of the pn-junction (12a, 12b), which is biased in the reverse direction, is set to a predetermined value, in that an edge area of the semiconductor body (1) which encloses this part of the edge region (11b) laterally is also removed by the etching step at the same time as the said part of the edge region (11b) of the semiconductor region, in that a dopant is introduced into a layer (23) of the semiconductor region (11a, 11b) on the surface side before the etching step, and in that this layer (23) on the surface side is removed again by the etching step from the edge region (11b) of the semiconductor region (11a, 11b) and from the edge area of the semiconductor body (1) surrounding it.

2. Method according to Claim 1, characterized in that the dopant which is introduced into the layer (23) of the semiconductor region (11a, 11b) and of the semiconductor body (1) on the surface side reinforces the doping of the semiconductor region (11a, 11b).

3. Method according to Claim 1, characterized in that the dopant which is introduced into the layer (23) of the semiconductor region (11a, 11b) and of the semiconductor body (1) on the surface side reverses the doping of the semiconductor region (11a, 11b) in the vicinity of the upper boundary surface (1a).

4. Use of the method according to Claim 1 or 2 for the production of a thyristor, the semiconductor region (11a, 11b) forming the p-base and the semiconductor body (1) forming the n-base, the p-emitter in the region of the lower boundary surface of the semiconductor body being produced by the same diffusion steps as the p-base but with a constant doping concentration in the lateral direction, and the n-emitter being introduced into the semiconductor region (11a, 11b) by means of an additional doping step.

5. Use of the method according to Claim 3 for the production of a thyristor, the semiconductor region (11a, 11b) forming the p-base, the semiconductor body (1) forming the n-base and that part of the layer (23) on the surface side which is introduced into the semiconductor region forming the n-emitter, and the p-emitter (32) being produced in the region of the lower boundary surface of the semiconductor body (1) by the same diffusion steps as the p-base, but with a constant doping concentration in the lateral direction.

6. Use of the method according to one of Claims 1 or 2 for the production of a diode, the semiconductor region (11a, 11b) forming the p-emitter, and the semiconductor body (1) forming the n-emitter of the same.

7. Use of the method according to Claim 3 for the production of bipolar transistor, the semiconductor region (11a, 11b) forming the base, the semiconductor body (1) forming the collector, and that part of the layer (23) on the surface side which is inserted into the semiconductor region (11a, 11b) forming the emitter.

## Revendications

1. Procédé de fabrication d'une jonction p-n planaire à haute tenue en tension qui sépare une zone semi-conductrice (11a, 11b) d'un deuxième type de conductivité, introduite dans un corps semi-conducteur (1) dopé d'un premier type de conductivité, de la partie restante du corps semi-conducteur (1), la portion (12b) limitant la partie périphérique (11b) de la zone semi-conductrice de la jonction p-n s'approchant progressivement de la surface limite supérieure (1a), la largeur de la partie périphérique (11b) de la zone semi-conductrice étant supérieure à la profondeur de pénétration de celle-ci et la partie périphérique (11b) présentant sur toute sa largeur une concentration du dopant diminuant au fur et à mesure que la distance par rapport à la partie centrale (11a) de la zone semi-conductrice augmente, dans lequel un dopant servant à former la zone semi-conductrice (11a, 11b) est d'abord introduit dans le corps semi-conducteur (1), à travers la surface limite supérieure (1a), et une partie du dopant introduit est diffusée plus profond dans le corps semi-conducteur (1) par une opération de recuit, caractérisé en ce qu'une portion partant de la surface limite supérieure (1a) de la partie périphérique (11b) de la zone semi-conductrice est supprimée après l'opération de recuit par une opération d'attaque, la profondeur d'attaque (17) étant calculée de manière à régler la tension de claquage superficielle de la jonction p-n (12a, 12b) précontrainte dans le sens de blocage sur une valeur prédéfinie, en ce que grâce à l'opération d'attaque, en même temps que ladite portion de la partie périphérique (11b) de la zone semi-conductrice, également une partie périphérique du corps semi-conducteur (1) est supprimée, qui entoure cette portion de la partie périphérique (11b) latéralement, en ce qu'avant l'opération d'attaque un dopant est introduit dans une couche (23) située au niveau de la surface de la zone semi-conductrice (11a, 11b) et du corps semi-conducteur (1) et en ce que grâce à l'opération d'attaque, cette couche (23) située au niveau de la surface est de nouveau supprimée dans la partie périphérique (11b) de la zone semi-conductrice (11a, 11b) et dans la zone périphérique du corps semi-conducteur (1) entourant celle-ci.

2. Procédé selon la revendication 1, caractérisé en ce que le dopant introduit dans la couche (23) située au niveau de la surface de la zone semi-conductrice (11a, 11b) et du corps semi-conducteur (1) renforce le dopage de la zone semi-conductrice (11a, 11b).

3. Procédé selon la revendication 1, caractérisé en ce que le dopant introduit dans la couche (23) située au niveau de la surface de la zone semi-conductrice (11a, 11b) et du corps semi-conducteur (1) inverse le dopage de la zone semi-conductrice (11a, 11b) à proximité de la surface limite supérieure (1a).

4. Application du procédé selon l'une des revendications 1 ou 2, en vue de la fabrication d'un thyristor, la zone semi-conductrice (11a, 11b) formant la base de type p et le corps semi-conducteur (1) la base de type n, l'émetteur de type p étant créé au niveau de la surface limite inférieure du corps semi-conducteur grâce aux mêmes opérations de diffusion que la base de type p, mais avec une concentration du dopant constante dans le sens latéral, et l'émetteur de type n étant introduit dans la zone semi-conductrice (11a, 11b) grâce à une opération de dopage supplémentaire.

5. Application du procédé selon la revendication 3, en vue de la fabrication d'un thyristor, la zone semi-conductrice (11a, 11b) formant la base de type p, le corps semi-conducteur (1) la base de type n et la partie introduite dans la zone semi-conductrice de la couche (23) située au niveau de la surface l'émetteur de type n, et l'émetteur de type p (32) étant créé au niveau de la surface limite inférieure du corps semi-conducteur (1) grâce aux mêmes opérations de diffusion que la base de type p, mais avec une concentration du dopant constante dans le sens latéral.

6. Application du procédé selon l'une des revendications 1 ou 2, en vue de la fabrication d'une diode, la zone semi-conductrice (11a, 11b) formant l'émetteur de type p et le corps semi-conducteur (1) l'émetteur de type n de celle-ci.

7. Application du procédé selon la revendication 3, en vue de la fabrication d'un transistor bipolaire, la zone semi-conductrice (11a, 11b) formant la base, le corps semi-conducteur (1) le collecteur et la partie introduite dans la zone semi-conductrice (11a, 11b) de la couche (23) située au niveau de la surface l'émetteur.
